# EUROPEAN PATENT SPECIFICATION

(11) **EP 4 206 697 B1**
(45) Date of publication and mention of the grant of the patent: **11.12.2024**
(21) Application number: 20953630.9
(22) Date of filing: 17.09.2020
(51) Int. Cl.: G01R 31/00, G01R 31/28, G01R 31/327, H03K 3/013, H03K 3/356, H03K 5/1254, H03K 17/22

(54) **SELF-LOCKING AND DETECTION CIRCUIT AND APPARATUS, AND CONTROL METHOD**
SELBSTSPERRENDE DETEKTIONSSCHALTUNG UND -VORRICHTUNG SOWIE STEUERUNGSVERFAHREN
CIRCUIT ET APPAREIL D'AUTO-VERROUILLAGE ET DE DÉTECTION, ET PROCÉDÉ DE COMMANDE

(43) Date of publication of application: 05.07.2023
(73) Proprietor: Zhejiang Geely Holding Group Co., Ltd., Hangzhou, Zhejiang 310051 (CN); Zhejiang Liankong Technologies Co., Ltd, Ningbo, Zhejiang 315336 (CN)
(72) Inventor: LIANG, Zhengyong, Hangzhouwan New District Ningbo, Zhejiang 315336 (CN); LIU, Gang, Hangzhouwan New District Ningbo, Zhejiang 315336 (CN); CHEN, Deting, Hangzhouwan New District Ningbo, Zhejiang 315336 (CN); PU, Wulin, Hangzhouwan New District Ningbo, Zhejiang 315336 (CN); ZHENG, Jiawei, Hangzhouwan New District Ningbo, Zhejiang 315336 (CN); HE, Yangfan, Hangzhouwan New District Ningbo, Zhejiang 315336 (CN); WANG, Yuanyuan, Hangzhouwan New District Ningbo, Zhejiang 315336 (CN); JIANG, Lingyan, Hangzhouwan New District Ningbo, Zhejiang 315336 (CN); LV, Yang, Hangzhouwan New District Ningbo, Zhejiang 315336 (CN); WENG, Shuhua, Hangzhouwan New District Ningbo, Zhejiang 315336 (CN); ZHAO, Chunyang, Hangzhouwan New District Ningbo, Zhejiang 315336 (CN); WU, Xuejian, Hangzhouwan New District Ningbo, Zhejiang 315336 (CN); TANG, Gong, Hangzhouwan New District Ningbo, Zhejiang 315336 (CN)
(74) Representative: Dehns Germany Partnerschaft mbB
(86) International application number: PCT/CN2020/115832
(87) International publication number: WO 2022/056772

(56) References cited:
- EP-A2- 2 308 148
- EP-B1- 2 308 148
- CN-A- 102 664 612
- CN-A- 102 664 612
- CN-A- 108 271 279
- CN-A- 108 271 279
- CN-A- 109 639 287
- CN-U- 208 547 701
- CN-U- 209 149 116
- JP-A- H01 126 015
- KR-B1- 101 093 805
- US-A- 5 541 544
- US-A1- 2002 036 535
- US-A1- 2003 151 313
- US-A1- 2011 316 609

## Description

### TECHNICAL FIELD

This invention relates to the field of electronic circuits, and in particular to a self-locking detection circuit and apparatus, and a control method.

### BACKGROUND

Electric self-locking means that when a start switch is pressed to energize a self-locking circuit, continuous energization of the self-locking circuit can be automatically maintained until the self-locking circuit is disconnected after unlocking. The existing self-locking circuit may only be unlocked by cutting off the power, which may cause an unlocked state to be cleared, and is not applicable to some applications in which the unlocking cannot be performed by cutting off the power.

The existing self-locking circuit has the following defects.
1) During power-on or MCU (Microcontroller Unit) initialization, self-locking of the self-locking circuit may be triggered by mistake, resulting in abnormal self-locking of the self-locking circuit.
2) It is impossible to check a self-locked state of the self-locking circuit in real time, and it is impossible to determine whether the self-locking circuit is abnormal.
3) The self-locking circuit in the self-locked state cannot be unlocked in a power-on mode.
4) It is impossible to detect and control the self-locking circuit in a closed loop.

In order to solve the above technical problems, it is necessary to provide a self-locking detection circuit, a self-locking detection apparatus, and a control method.

US 2003/0151313 A1 relates to a control apparatus having a momentary switch. In response to an operation performed on a momentary switch, a latch circuit switches a latch output signal to be outputted to a microcomputer from "high" to "low" and keeps the latch output signal "low". A capacitor supplies an electric power to the latch circuit when supply of the electric power is cut off. A reset circuit sends a signal to the latch circuit in response to an input of a high-level latch reset signal from the microcomputer so that the latch circuit switches the latch output signal from "low" to "high". If the latch output signal is "high" when the microcomputer detects that the switch is operated, a transistor is turned on under the control of the microcomputer. If the latch output signal is "low" when the microcomputer detects that the switch is operated, the transistor is turned off under the control of the microcomputer. The microcomputer outputs the high-level latch reset signal to the reset circuit.

EP 2 308 148 A2 relates to an electric standby circuit for an electric appliance. The circuit comprises a switch adapted to open and close an electric connection between a first input and an output of the circuit, and a bistable circuit electrically connected to the switch in order to control the opening and closing thereof. The bistable circuit comprises a first BJT transistor of the pnp type and a second BJT transistor of the npn type. The first transistor is connected to the first input through the emitter, and the collector of the first transistor is connected to the base of the second transistor through a first resistor. The collector of the second transistor is connected to the switch and to a second input through a second resistor. The base of the first transistor is connected to the second input through a third resistor.

US 2011/0316609 A1 relates to an on-off power circuit connecting a voltage source to a digital system. The on-off power having a turn-on signal source, a control bipolar junction transistor, a switching bipolar junction transistor, a turn-off bipolar junction transistor, and a turn-off signal source. The circuit is activated by a turn-on signal and deactivated by a turn-off signal.

US 5,541,544 A relates to a semiconductor integrated bipolar flip-flop circuit that prevents or suppresses erroneous operation arising from a current induced by external noise and flowing through a parasitic capacitance associated with a p-type diffused resistor. The semiconductor integrated circuit includes bipolar transistors that are directly involved with set and reset operations of the flip-flop circuit having bases connected to a two-stage inverter including bipolar transistors so that the bases of the bipolar transistors involved in setting and resetting are not connected directly to a p-type diffused resistor.

CN 108 271 279 A provides a starting control circuit of a clothes dryer. The starting control circuit comprises: a strong current door switch detection circuit configured to output first detection signals when a strong current door switch of a clothes dryer is closed and output second detection signals when the strong current door switch of the clothes dryer is opened; and a control signal generation circuit comprising a first input end configured to receive the first detection signals or the second detection signals, a second input end configured to receive connection signals or disconnection signals of a starting switch of the clothes dryer, a third input end configured to receive load control signals sent by a controller of the clothes dryer, and an output end configured to generate starting control signals. The circuit is low in cost and long in life.

CN 102 664 612 A provides a control device for automatic disconnection of a power switch triggered at one time. The control device comprises the power switch, a self-locking circuit, a signal detection circuit, a self-locking connection and disconnection control module and a key triggering module, wherein the power switch is used for receiving a control signal of the self-locking circuit; the self-locking circuit is used for receiving a triggering signal of the key triggering module and a control signal of the self-locking connection and disconnection control module, and sending a control signal to the power switch after processing the signals; the signal detection circuit is used for detecting the triggering times of the key triggering module, sending the triggering times to the self-locking connection and disconnection control module, and sending a control signal to the self-locking circuit after the triggering times are processed by the self-locking connection and disconnection control module; the self-locking connection and disconnection control module is used for receiving the triggering times detected by the signal detection circuit; and the key triggering module is used for transmitting the triggering signal. The control device has the advantages that control is flexible, energy is saved, the service life is prolonged, the problem of current leakage of equipment is solved, and potential safety hazards are eliminated.

### SUMMARY

In view of the above problems in the related art, an objective of this invention is to provide a self-locking detection circuit, a self-locking detection apparatus, and a control method, which are resistant to interference and have high reliability and safety. Level signals at a first terminal and a second terminal are detected after a low-level signal is input to a first input end, such that a self-locked state of a self-locking circuit can be checked in real time, and the self-locking circuit can be controlled to unlock the self-locked state in a power-on mode, while solving the problem that the self-locking circuit may be triggered by mistake during power-on or MCU (Microcontroller Unit) initialization.

In order to achieve the above objective, this invention provides a self-locking detection circuit having the features of claim 1, a self-locking detection apparatus having the features of claim 4 and a method of controlling the self-locking detection apparatus having the features of claim 7.

In a particular embodiment, the first end of the first transistor is electrically connected with the second end of the second transistor, a second end of the first transistor is electrically connected with a first end of the second transistor, and a third end of the first transistor is configured to be electrically connected with the power terminal; a third end of the second transistor is grounded; and the first input end is electrically connected with the first end of the third transistor.

In a particular embodiment, the self-locking circuit further includes a second input end, the second input end being electrically connected with the second end of the first transistor, and the second input end being configured to be electrically connected with a second output end of the controller.

In a particular embodiment, the self-locking detection circuit further includes a power-on delay circuit, where the power-on delay circuit includes a first resistor and a capacitor, a third end of the first transistor is electrically connected with the power terminal via the first resistor, the third end of the first transistor is electrically connected with one end of the capacitor, and the other end of the capacitor is grounded.

In a particular embodiment, the self-locking detection circuit further includes an anti-reverse diode, where the first terminal, the first end of the first transistor, and the first end of the third transistor are electrically connected with the first input end via the anti-reverse diode, and an anode of the anti-reverse diode is electrically connected with the first end of the third transistor, and a cathode of the anti-reverse diode is electrically connected with the first input end.

In a particular embodiment, the first transistor, the second transistor, and the third transistor are field effect transistors.

In a particular embodiment, the first transistor is a P-channel MOS transistor, the second transistor is an N-channel MOS transistor, and the third transistor is a P-channel MOS transistor.

In a particular embodiment, the self-locking circuit further includes a first current-limiting resistor and a second current-limiting resistor, where the anode of the anti-reverse diode is electrically connected with the first end of the first transistor via the first current-limiting resistor, and the second input end is electrically connected with the first end of the second transistor via the second current-limiting resistor.

In a particular embodiment, the controller further includes a third input end and a fourth input end, where the first terminal is electrically connected with the third input end, and the second terminal is electrically connected with the fourth input end.

In a particular embodiment, the self-locking detection apparatus further includes a fault alarm device electrically connected with the controller.

In a particular embodiment, in the preset condition, the signal output from the first terminal is a low-level signal and the signal output from the second terminal is a high-level signal.

In a particular embodiment, the method further includes:
determining whether a number of faults in the self-locking circuit reaches a preset number, if the preset condition is not satisfied;
if the number of the faults in the self-locking circuit reaches the preset number, sending an alarm signal from the controller; and
if the number of the faults in the self-locking circuit does not reach the preset number, increasing the number of the faults in the self-locking circuit by one, unlocking the self-locking circuit, outputting the low-level signal to the first input end, and returning to determining whether the signals output from the first terminal and the second terminal satisfy the preset condition.

In a particular embodiment, unlocking the self-locking circuit includes: outputting the low-level signal to the second input end from the controller.

The present application has obvious advantages and beneficial effects compared with the related art. By virtue of the above technical solutions, the self-locking detection circuit, the self-locking detection apparatus, and the method of controlling the self-locking detection apparatus according to the present application can achieve considerable technological progress and practical applicability and can be widely used in industry, and at least have the following advantages.
1) The self-locking detection circuit and apparatus, and the control method provided in this specification are resistant to interference and have high reliability and safety. The level signals at the first terminal and the second terminal are detected after the low-level signal is input to the first input end, such that the self-locked state of the self-locking circuit can be checked in real time, and the self-locking circuit can be controlled to unlock the self-locked state in a power-on mode.
2) The addition of the power-on delay circuit can prevent the self-locking circuit from entering an unexpected state due to power-on and MCU initialization, resulting in false triggering of the self-locking circuit.
3) A virtual voltage generated by a junction capacitor of the third transistor is rapidly bled off through the bleeder resistor, such that a voltage at the second terminal can be rapidly increased to a high level or rapidly decreased to a low level when the third transistor is in an on or off state.
4) The anti-reverse diode can prevent interference into ports of the controller while operating with the self-locking circuit.
5) After it is detected that the self-locking circuit does not satisfy the preset condition, the self-locking circuit is controlled to be unlocked and then the self-locked state of the self-locking circuit is determined again, such that the self-locking circuit can be detected and controlled in a closed loop.

### BRIEF DESCRIPTION OF THE DRAWINGS

In order to explain the technical solutions of the present invention more clearly, the drawings to be used in description of embodiments or the related art will be briefly introduced below. It is apparent that the drawings in the following description merely illustrate some embodiments of the present invention, and other drawings may be obtained from these drawings by those ordinary skilled in the art without any creative efforts.
FIG. 1 is a schematic circuit diagram of a self-locking detection circuit according to an embodiment of the present invention.
FIG. 2 is a flowchart of a method of controlling a self-locking detection apparatus according to an embodiment of the present invention.
FIG. 3 is a structural block diagram of a self-locking detection apparatus according to an embodiment of the present invention.

### Reference signs

1 - first transistor, 2 - second transistor, 3 - third transistor, 4 - first resistor, 5 - first current-limiting resistor, 6 - pull-up resistor, 7 - second current-limiting resistor, 8 - capacitor, 9 - anti-reverse diode, 10 - first terminal, 11 - second terminal, 12 - first input end, 13 - second input end, 14 - bleeder resistor, 15 - controller, 16 - fault alarm device.

### DETAILED DESCRIPTION OF THE EMBODIMENTS

The technical solutions in embodiments of the present invention will be clearly and completely described below in conjunction with the drawings in the embodiments of the present invention. It is apparent that the described embodiments are merely some of the embodiments of the present invention, rather than all of the embodiments. Based on the embodiments of the present invention, all other embodiments obtained by those ordinary skilled in the art without any creative efforts fall within the scope of protection of the present invention.

In several embodiments provided in the present application, the described system embodiments are merely illustrative. For example, the described division of modules is only a logical function division, and there may be other divisions in actual implementations. For example, multiple modules or components may be combined or integrated into another system, or some features may be omitted or not performed. On the other hand, mutual coupling or direct coupling, or communication connection as shown or discussed may be indirect coupling or communication connection through some interfaces, modules or units, either in electrical or other forms.

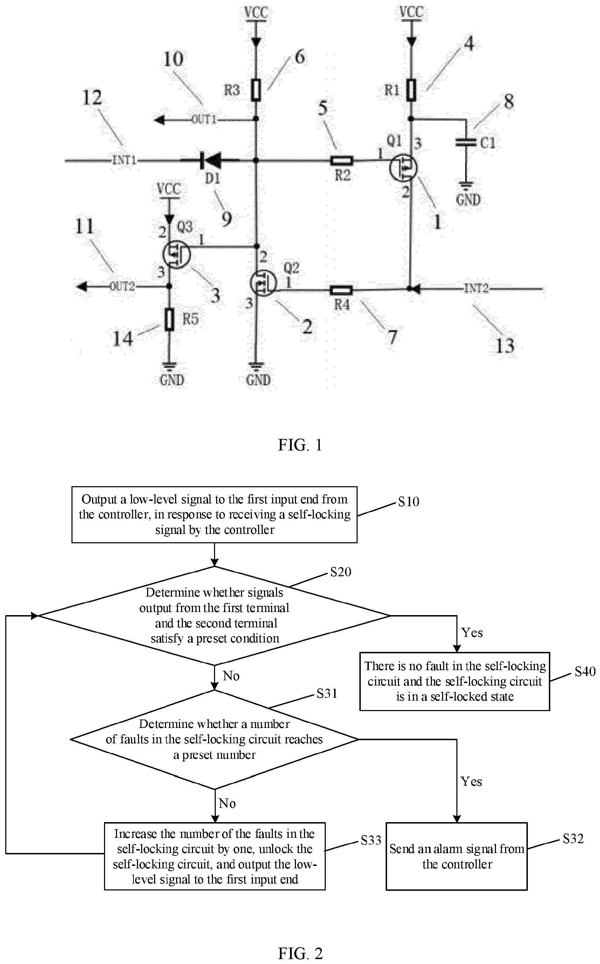

The present application provides a self-locking detection circuit. As shown in FIG. 1, the self-locking detection circuit includes a self-locking circuit and a detection circuit. The self-locking circuit includes a three-terminal transistor group and a first input end 12, the three-terminal transistor group including a first transistor 1 and a second transistor 2. The detection circuit includes a pull-up resistor 6, a bleeder resistor 14, and a third transistor 3. A first end of the pull-up resistor 6 is electrically connected with a first end of the first transistor 1, and a second end of the pull-up resistor 6 is configured to be electrically connected with a power terminal. A first end of the third transistor 3 is electrically connected with a second end of the second transistor 2, a second end of the third transistor 3 is configured to be electrically connected with the power terminal, and a third end of the third transistor 3 is grounded via the bleeder resistor 14. The first end of the pull-up resistor 6 is provided with a first terminal 10 for signal output, and the third end of the third transistor 3 is provided with a second terminal 11 for signal output. The first input end 12 is provided between the first end of the third transistor 3 and the first terminal 10, and the first input end 12 is configured to receive a level signal output from a controller 15.

The self-locking detection circuit provided in the present application is resistant to interference and has high reliability and safety. Level signals at the first terminal and the second terminal are detected after a low-level signal is input to the first input end, such that a self-locked state of the self-locking circuit can be checked in real time. In addition, a virtual voltage generated by a junction capacitor of the third transistor is rapidly bled off through the bleeder resistor, such that a voltage at the second terminal can be rapidly increased to a high level or rapidly decreased to a low level when the third transistor is in an on or off state.

Further, in this embodiment, the first transistor 1, the second transistor 2, and the third transistor 3 are all field effect transistors. The first transistor 1 is a P-channel MOS (Metal Oxide Semiconductor) transistor, the second transistor 2 is an N-channel MOS transistor, and the third transistor 3 is a P-channel MOS transistor. Three terminals of each of the first transistor 1, the second transistor 2, and the third transistor 3 include a first end, a second end, and a third end, corresponding to gate, drain and source of the MOS transistor, respectively.

Further, the first end of the first transistor 1 is electrically connected with the second end of the second transistor 2, a second end of the first transistor 1 is electrically connected with a first end of the second transistor 2, and a third end of the first transistor 1 is configured to be electrically connected with the power terminal. A third end of the second transistor 2 is grounded. The first input end 12 is electrically connected with the first end of the third transistor 3. With the self-locking circuit including the first transistor 1, the second transistor 2, and other electrical elements, a self-locking function can be realized by inputting a low-level signal to the first input end 12.

Further, the self-locking circuit further includes a second input end 13, the second input end 13 being electrically connected with the second end of the first transistor 1, and the second input end 13 being configured to be electrically connected with a second output end of the controller 15. An unlocking function of the self-locking circuit can be realized by inputting a low-level signal to the second input end 13.

Further, the self-locking detection circuit further includes a power-on delay circuit. The power-on delay circuit includes a first resistor 4 and a capacitor 8, a third end of the first transistor 1 is electrically connected with the power terminal via the first resistor 4, the third end of the first transistor 1 is electrically connected with one end of the capacitor 8, and the other end of the capacitor 8 is grounded. With the power-on delay circuit including the first resistor 4 and the capacitor 8, false triggering of the self-locking circuit due to an initialization state of the controller 15 such as an MCU can be prevented.

Further, the self-locking detection circuit further includes an anti-reverse diode 9. The first terminal 10, the first end of the first transistor 1, and the first end of the third transistor 3 are electrically connected with the first input end 12 via the anti-reverse diode 9. An anode of the anti-reverse diode 9 is electrically connected with the first end of the third transistor 3, and a cathode of the anti-reverse diode 9 is electrically connected with the first input end 12. The anti-reverse diode 9 is configured to prevent interference into ports of the controller while operating with the self-locking circuit.

Further, in this embodiment, the first transistor 1, the second transistor 2, and the third transistor 3 are field effect transistors. The first transistor 1 is a P-channel MOS transistor, the second transistor 2 is an N-channel MOS transistor, and the third transistor 3 is a P-channel MOS transistor. In other embodiments, the first transistor 1, the second transistor 2, and the third transistor 3 may be other three-terminal transistors that can realize the functions of the present application, such as triodes.

Further, the self-locking circuit further includes a first current-limiting resistor 5 and a second current-limiting resistor 7. The anode of the anti-reverse diode 9 is electrically connected with the first end of the first transistor 1 via the first current-limiting resistor 5, and the second input end 13 is electrically connected with the first end of the second transistor 2 via the second current-limiting resistor 7. Current in the self-locking circuit is limited by the first current-limiting resistor 5 and the second current-limiting resistor 7 to avoid excessive current in the self-locking circuit, thereby protecting circuit components.

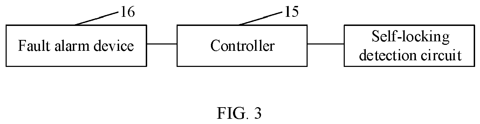

In another aspect, the present application further provides a self-locking detection apparatus. As shown in FIG. 3, the self-locking detection apparatus includes a controller 15 and the self-locking detection circuit as described above. The controller 15 at least includes a first output end and a second output end, the first output end being electrically connected with the first input end 12, and the second output end being electrically connected with the second input end 13. The controller is configured to send a level signal to the first input end 12 via the first output end and to send a level signal to the second input end 13 via a second output end.

Further, the controller 15 further includes a third input end and a fourth input end. The first terminal 10 is electrically connected with the third input end, and the second terminal 11 is electrically connected with the fourth input end. In this embodiment, control signals output from the first terminal and the second terminal are received by the third input end and the fourth input end of the controller 15, respectively. In other embodiments, the above control signals can be received by other controllers, for example, a first controller and a second controller electrically connected with the first controller, and the control signals are output from the first controller and received by the second controller.

Further, the self-locking detection apparatus further includes a fault alarm device 16 electrically connected with the controller 15. The fault alarm device 16 is configured to send an alarm upon receiving an alarm signal from the controller.

In another aspect, as shown in FIG. 2, the present application further provides a method of controlling a self-locking detection apparatus. The method is configured to control the self-locking detection apparatus as described above, and the method includes the following steps.

At S10, the controller, in response to receiving a self-locking signal, outputs a low-level signal to the first input end.

At S20, it is determined whether signals output from the first terminal and the second terminal satisfy a preset condition.

At S40, it is determined that there is no fault in the self-locking circuit and the self-locking circuit is in a self-locked state, if the preset condition is satisfied.

Level signals at the first terminal and the second terminal are detected after a low-level signal is input to the first input end, such that the self-locked state of the self-locking circuit can be checked in real time.

Further, in the preset condition, the signal output from the first terminal is a low-level signal and the signal output from the second terminal is a high-level signal.

If the signal output from the first terminal is a low-level signal and the signal output from the second terminal is a high-level signal, it can be determined that the self-locking circuit is in a normal self-locked state. If the above condition is not satisfied, that is, if the detected level signals output from the first terminal and the second terminal are inconsistent with the above signals, the self-locking is considered abnormal.

Further, after determining whether the signals output from the first terminal and the second terminal satisfy the preset condition, the method further includes:
S31: determining whether a number of faults in the self-locking circuit reaches a preset number, if the preset condition is not satisfied;
S32: if the number of the faults in the self-locking circuit reaches the preset number, sending an alarm signal from the controller; and
S33: if the number of the faults in the self-locking circuit does not reach the preset number, increasing the number of the faults in the self-locking circuit by one, unlocking the self-locking circuit, outputting the low-level signal to the first input end, and returning to determining whether the signals output from the first terminal and the second terminal satisfy the preset condition.

If it is detected that the self-locking circuit is abnormal, the self-locking circuit is controlled to be unlocked and then self-locked again, and the self-locked state is detected. If the detected state is still abnormal and the self-locking circuit is abnormal, a power-off process can be entered to realize closed-loop control of the self-locking detection circuit. After it is detected that the self-locking circuit does not satisfy the preset condition, the self-locking circuit is controlled to be unlocked and then the self-locked state of the self-locking circuit is determined again, such that the self-locking circuit can be detected and controlled in a closed loop. In this embodiment, the preset number is three, and if it is detected that the number of the faults in the self-locking circuit reaches three, it is determined that the self-locking circuit is faulty, and a fault signal is sent to the fault alarm device, such that the fault alarm device sends an alarm.

Further, unlocking the self-locking circuit includes: outputting the low-level signal to the second input end from the controller.

Since the controller outputs the low-level signal to the second input end, a potential at the second input end is decreased, and the second transistor 2 enters an off state, such that the self-locking circuit is unlocked and changed from the self-locked state to a non-self-locked state.

The present application further provides a storage medium having a computer program stored therein, where the computer program, when executed by a processor, causes the processor to perform the method of controlling the self-locking detection apparatus as described above.

The present application further provides a computer device, which includes a memory and a processor, where the memory has a computer program stored therein, and the computer program, when executed by the processor, causes the processor to perform the method of controlling the self-locking detection apparatus as described above.

The operating principle of the present application is as follows.
1) After receiving the self-locking signal, the controller performs power-on initialization. When the power-on initialization is completed, the controller outputs a low-level signal to the first input end, causing the gate of the first transistor to drop to a low potential. Since the source of the first transistor is connected to the power terminal via the power-on delay circuit, the first transistor enters an on state at this time. The gate of the second transistor changes from a low potential to a high potential because the first transistor enters the on state, and the second transistor enters an on state at this time because the source of the second transistor is grounded. Due to the on state of the second transistor, the gate of the first transistor is at a low potential and remains at the low potential until an unlocking signal is received, that is, the self-locking circuit enters the self-locked state.
2) When the self-locking circuit enters the self-locked state, the potential at the first terminal is low, and the potential at the second terminal is high, according to the principle of the self-locking circuit described above. Therefore, it can be determined whether the self-locking circuit is in the self-locked state by detecting the level signals at the first terminal and the second terminal. If it is detected that the first terminal is not at a low potential or the second terminal is not at a high potential, the self-locking circuit can be considered to be in an abnormal state at this time.
3) If it is detected that the self-locking circuit is in an abnormal state, the controller outputs a low-level signal to the second input end to unlock the self-locking circuit, and then the controller controls the self-locking circuit to perform self-locking and detection again. If the self-locking circuit enters the self-locked state after the self-locking is performed again, the self-locking circuit can perform normal self-locking, and if the normal self-locking cannot be performed within a preset number of times, it is determined that the self-locking circuit is abnormal and enters the power-off process to realize closed-loop control of the self-locking circuit.

With the above specific embodiments, the following technical effects are achieved.
1) The self-locking detection circuit and apparatus, and the control method provided in this specification are resistant to interference and have high reliability and safety. The level signals at the first terminal and the second terminal are detected after the low-level signal is input to the first input end, such that the self-locked state of the self-locking circuit can be checked in real time, and the self-locking circuit can be controlled to unlock the self-locked state in a power-on mode.
2) The addition of the power-on delay circuit can prevent the self-locking circuit from entering an unexpected state due to power-on and MCU initialization, resulting in false triggering of the self-locking circuit.
3) A virtual voltage generated by a junction capacitor of the third transistor is rapidly bled off through the bleeder resistor, such that a voltage at the second terminal can be rapidly increased to a high level or rapidly decreased to a low level when the third transistor is in an on or off state.
4) The anti-reverse diode can prevent interference into ports of the controller while operating with the self-locking circuit.
5) After it is detected that the self-locking circuit does not satisfy the preset condition, the self-locking circuit is controlled to be unlocked and then the self-locked state of the self-locking circuit is determined again, such that the self-locking circuit can be detected and controlled in a closed loop.

It should be noted that for simplicity of description, each of the foregoing method embodiments is described as a combination of two series of actions, but it should be understood by those skilled in the art that the present invention is not limited by the order of the actions described, as certain steps may be performed in other orders or simultaneously in accordance with the present invention. Similarly, each module of the above self-locking detection apparatus refers to a computer program or a program segment, which is configured to perform one or more specific functions. Furthermore, the division of the above modules does not mean that the actual program code must also be separated. In addition, any combination of the above embodiments can be made to obtain other embodiments.

In the above embodiments, the description of each embodiment has its own emphasis, and parts of each embodiment that are not described in detail can be found in the relevant descriptions of other embodiments. Those skilled in the art can also appreciate that various illustrative logical blocks, units, and steps described in the embodiments of the present invention may be implemented by electronic hardware, computer software, or a combination of both. In order to clearly demonstrate the interchangeability of hardware and software, the various illustrative components, units, and steps described above have their functions described in general terms. Whether such functions are implemented in hardware or software depends on the particular application and the design requirements of the overall system. Those skilled in the art can implement the described functions using a variety of methods for each particular application, but such implementation should not be construed as going beyond the protection scope of the embodiments of the present invention.

The above description has sufficiently disclosed specific embodiments of the present invention. It is to be noted that modifications may be made to the specific embodiments of the present invention by those skilled in the art without departing from the scope of the claims of the present invention. Accordingly, the scope of the claims of the present invention is not limited only to the specific embodiments described above.

## Claims

1. A self-locking detection circuit, **characterized in that** the self-locking detection circuit comprises a self-locking circuit, a detection circuit, a power-on delay circuit, and an anti-reverse diode (9), wherein
the self-locking circuit comprises a three-terminal transistor group, a first input end (12), a second input end (13), a first current-limiting resistor (5), and a second current-limiting resistor (7), the three-terminal transistor group comprising a first transistor (1) and a second transistor (2),
the detection circuit comprises a pull-up resistor (6), a bleeder resistor (14), and a third transistor (3),
the power-on delay circuit comprises a first resistor (4) and a capacitor (8), and
a gate of the first transistor (1) is electrically connected with a drain of the second transistor (2) via the first current-limiting resistor (5), a drain of the first transistor (1) is electrically connected with a gate of the second transistor (2) via the second current-limiting resistor (7), a source of the first transistor (1) is electrically connected with a power terminal via the first resistor (4), and a source of the second transistor (2) is grounded; a first end of the pull-up resistor (6) is electrically connected with the gate of the first transistor (1) via the first current-limiting resistor (5), and a second end of the pull-up resistor (6) is configured to be electrically connected with the power terminal; a gate of the third transistor (3) is electrically connected with the drain of the second transistor (2), a drain of the third transistor (3) is configured to be electrically connected with the power terminal, and a source of the third transistor (3) is grounded via the bleeder resistor (14); the first end of the pull-up resistor (6) is provided with a first terminal (10) for signal output, and the source of the third transistor (3) is provided with a second terminal (11) for signal output; the first input end (12) is provided between the gate of the third transistor (3) and the first terminal (10), the first input end (12) is electrically connected with a cathode of the anti-reverse diode (9), and the first input end (12) is configured to receive a level signal output from a controller (15); the second input end (13) is electrically connected with the drain of the first transistor (1), and the second input end (13) is electrically connected with the gate of the second transistor (2) via the second current-limiting resistor (7); an anode of the anti-reverse diode (9) is electrically connected with the gate of the third transistor (3), and the anode of the anti-reverse diode (9) is electrically connected with the gate of the first transistor (1) via the first current-limiting resistor (5); and one end of the capacitor (8) is electrically connected with the source of the first transistor (1), and the other end of the capacitor (8) is grounded.

2. The self-locking detection circuit according to claim 1, **characterized in that**, the first transistor (1), the second transistor (2), and the third transistor (3) are field effect transistors.

3. The self-locking detection circuit according to claim 2, **characterized in that**, the first transistor (1) is a P-channel MOS transistor, the second transistor (2) is an N-channel MOS transistor, and the third transistor (3) is a P-channel MOS transistor.

4. A self-locking detection apparatus, **characterized in that** the self-locking detection apparatus comprises a controller (15) and the self-locking detection circuit according to any one of claims 1-3, wherein the controller (15) at least comprises a first output end and a second output end, the first output end being electrically connected with the first input end (12), and the second output end being electrically connected with the second input end (13).

5. The self-locking detection apparatus according to claim 4, **characterized in that**, the controller (15) further comprises a third input end and a fourth input end, wherein the first terminal (10) is electrically connected with the third input end, and the second terminal (11) is electrically connected with the fourth input end.

6. The self-locking detection apparatus according to claim 4, **characterized in that**, the self-locking detection apparatus further comprises a fault alarm device (16) electrically connected with the controller (15).

7. A method of controlling the self-locking detection apparatus according to any one of claims 4-6, **characterized in that** the method comprises:
outputting a low-level signal to the first input end from the controller, in response to receiving a self-locking signal by the controller;
determining whether signals output from the first terminal and the second terminal satisfy a preset condition; and
determining that there is no fault in the self-locking circuit and the self-locking circuit is in a self-locked state, if the preset condition is satisfied.

8. The method according to claim 7, **characterized in that**, in the preset condition, the signal output from the first terminal is a low-level signal and the signal output from the second terminal is a high-level signal.

9. The method according to claim 7, **characterized in that**, the method further comprises:
determining whether a number of faults in the self-locking circuit reaches a preset number, if the preset condition is not satisfied;
if the number of the faults in the self-locking circuit reaches the preset number, sending an alarm signal from the controller; and
if the number of the faults in the self-locking circuit does not reach the preset number, increasing the number of the faults in the self-locking circuit by one, unlocking the self-locking circuit, outputting the low-level signal to the first input end, and returning to determining whether the signals output from the first terminal and the second terminal satisfy the preset condition.

10. The method according to claim 9, **characterized in that**, unlocking the self-locking circuit comprises: outputting the low-level signal to the second input end from the controller.

## Patentansprüche

1. Schaltung zur Erkennung der Selbstverriegelung, **dadurch gekennzeichnet, dass** sie eine Selbstverriegelungsschaltung, eine Erkennungsschaltung, eine Einschaltverzögerungsschaltung und eine Antireverse-Diode (9) umfasst, wobei die Selbstverriegelungsschaltung einen Subtransistorsatz mit drei Anschlüssen, ein erstes Eingabeende (12), ein zweites Eingabeende (13), einen ersten Strombegrenzungswiderstand (5) und einen zweiten Strombegrenzungswiderstand (7) umfasst, und wobei der Subtransistorsatz mit drei Anschlüssen einen ersten Transistor (1) und einen zweiten Transistor (2) umfasst, und wobei die Erkennungsschaltung einen Pull-up-Widerstand (6), einen Entladewiderstand (14) und einen dritten Transistor (3) umfasst, und wobei die Einschaltverzögerungsschaltung einen ersten Widerstand (4) und einen Kondensator (8) umfasst, und wobei das Gate des ersten Transistors (1) über den ersten Strombegrenzungswiderstand (5) mit dem Drain des zweiten Transistors (2) elektrisch verbunden ist, und wobei der Drain des ersten Transistors (1) über den zweiten Strombegrenzungswiderstand (7) mit dem Gate des zweiten Transistors (2) elektrisch verbunden ist, und wobei die Source des ersten Transistors (1) über den ersten Widerstand (4) mit dem Stromversorgungsende elektrisch verbunden ist, und wobei die Source des zweiten Transistors (2) geerdet ist, und wobei ein erstes Ende des Pull-up-Widerstandes (6) über den ersten Strombegrenzungswiderstand (5) mit dem Gate des ersten Transistors (1) elektrisch verbunden ist, und wobei ein zweites Ende des Pull-up-Widerstandes (6) zur elektrischen Verbindung mit dem Stromversorgungsende verwendet wird, und wobei das Gate des dritten Transistors (3) mit dem Drain des zweiten Transistors (2) elektrisch verbunden ist, und wobei der Drain des dritten Transistors (3) zur elektrischen Verbindung mit dem Stromversorgungsende verwendet wird, und wobei die Source des dritten Transistors (3) über den Entladewiderstand (14) geerdet ist, und wobei ein erstes Ende des Pull-up-Widerstandes (6) mit einem ersten Anschluss (10) zum Signalausgang versehen ist, und wobei die Source des dritten Transistors (3) mit einem zweiten Anschluss (11) zum Signalausgang versehen ist, und wobei das erste Eingabeende (12) zwischen dem Gate des dritten Transistors (3) und dem ersten Anschluss (10) angeordnet ist, und wobei das erste Eingabeende (12) mit der Kathode der Antireverse-Diode (9) elektrisch verbunden ist, und wobei das erste Eingabeende (12) dazu verwendet wird, ein von dem Steuergerät (15) gesendetes Pegelsignal zu empfangen, und wobei das zweite Eingabeende (13) mit dem Drain des ersten Transistors (1) elektrisch verbunden ist, und wobei das zweite Eingabeende (13) über den zweiten Strombegrenzungswiderstand (17) mit dem Gate des zweiten Transistors (2) elektrisch verbunden ist, und wobei die Anode der Antireverse-Diode (9) mit dem Gate des dritten Transistors (3) elektrisch verbunden ist, und wobei die Anode der Antireverse-Diode (9) über den ersten Strombegrenzungswiderstand (5) mit dem Gate des ersten Transistors (1) elektrisch verbunden ist, und wobei ein Ende des Kondensators (8) mit der Source des ersten Transistors (1) elektrisch verbunden ist, und wobei das andere Ende des Kondensators (8) geerdet ist.

2. Schaltung zur Erkennung der Selbstverriegelung nach Anspruch 1, **dadurch gekennzeichnet, dass** der erste Transistor (1), der zweite Transistor (2) und der dritte Transistor (3 jeweils eine Feldeffektröhre sind.

3. Schaltung zur Erkennung der Selbstverriegelung nach Anspruch 2, **dadurch gekennzeichnet, dass** der erste Transistor (1) eine P-Kanal-MOS-Röhre, der zweite Transistor (2) eine N-Kanal-MOS-Röhre und der dritte Transistor (3) eine P-Kanal-MOS-Röhre ist.

4. Vorrichtung zur Erkennung der Selbstverriegelung, **dadurch gekennzeichnet, dass** sie ein Steuergerät (15) und eine Schaltung zur Erkennung der Selbstverriegelung nach einem der Ansprüche 1 bis 3 umfasst, wobei das Steuergerät (15) mindestens ein erstes Ausgabeende und ein zweites Ausgabeende umfasst, und wobei das erste Ausgabeende mit dem ersten Eingabeende (12) und das zweite Ausgabeende mit dem zweiten Eingabeende (13) elektrisch verbunden ist.

5. Vorrichtung zur Erkennung der Selbstverriegelung nach Anspruch 4, **dadurch gekennzeichnet, dass** das Steuergerät (15) weiterhin ein dritte Eingabeende und ein viertes Eingabeende umfasst, wobei der erste Anschluss (10) mit dem dritten Eingabeende elektrisch verbunden ist, und wobei der zweite Anschluss (11) mit dem vierten Eingabeende elektrisch verbunden ist.

6. Vorrichtung zur Erkennung der Selbstverriegelung nach Anspruch 4, **dadurch gekennzeichnet, dass** sie weiterhin eine Fehlermeldevorrichtung (16) umfasst, die mit dem Steuergerät (15) elektrisch verbunden ist.

7. Steuerverfahrens für eine Vorrichtung zur Erkennung der Selbstverriegelung, wobei das Verfahren zum Steuern einer Vorrichtung zur Erkennung der Selbstverriegelung nach einem der Ansprüche 4 bis 6 verwendet wird, **dadurch gekennzeichnet, dass** das Verfahren Folgendes umfasst:
wenn das Steuergerät ein Selbstverriegelungssignal empfängt, sendet das Steuergerät ein Signal mit niedrigem Pegel an das erste Eingabeende;
Beurteilen, ob ein von dem ersten Anschluss und dem zweiten Anschluss gesendetes Signal die voreingestellte Bedingung erfüllt; wenn die voreingestellte Bedingung erfüllt ist, wird es festgestellt, dass die Selbstverriegelungsschaltung keinen Fehler hat und sich die Selbstverriegelungsschaltung im selbstverriegelten Zustand befindet.

8. Steuerverfahrens für eine Vorrichtung zur Erkennung der Selbstverriegelung nach Anspruch 7, **dadurch gekennzeichnet, dass** die voreingestellte Bedingung darin besteht, dass das von dem ersten Anschluss ausgegebene Signal ein Signal mit niedrigem Pegel und das von dem zweiten Anschluss ausgegebene Signal ein Signal mit hohem Pegel ist.

9. Steuerverfahrens für eine Vorrichtung zur Erkennung der Selbstverriegelung nach Anspruch 7, **dadurch gekennzeichnet, dass** das Verfahren weiterhin Folgendes umfasst:
wenn die voreingestellte Bedingung nicht erfüllt ist, Beurteilen, ob die Anzahl der Fehler der Selbstverriegelungsschaltung die voreingestellte Anzahl von Malen erreicht; wenn die Anzahl der Fehler der Selbstverriegelungsschaltung die voreingestellte Anzahl von Malen erreicht, gibt das Steuergerät ein Alarmsignal aus;
wenn die Anzahl der Fehler der Selbstverriegelungsschaltung die voreingestellte Anzahl von Malen nicht erreicht, Erhöhen der Anzahl der Fehler der Selbstverriegelungsschaltung um 1, Entriegeln der Selbstverriegelungsschaltung, Ausgeben eines Signals mit niedrigem Pegel an das erste Eingabeende und Zurückkehren zu dem Schritt zum Beurteilen, ob das von dem ersten Anschluss und dem zweiten Anschluss ausgegebene Signal die voreingestellte Bedingung erfüllt.

10. Steuerverfahrens für eine Vorrichtung zur Erkennung der Selbstverriegelung nach Anspruch 9, **dadurch gekennzeichnet, dass** das Entriegeln der Selbstverriegelungsschaltung umfasst, dass das Steuergerät ein Signal mit niedrigem Pegel an das zweite Eingabeende sendet.

## Revendications

1. Un circuit de détection d'auto-blocage, **caractérisé en ce qu'**il comprend un circuit d'auto-blocage, un circuit de détection, un circuit de retard d'Ascension de Tension et une diode anti-diffusion (9),
le circuit d'auto-blocage comprend un groupe de transistors à trois bornes, une première entrée (12), une seconde entrée (13), une première résistance de limitation de courant (5) et une seconde résistance de limitation de courant (7), le groupe de transistors à trois bornes comprenant un premier transistor (1) et un second transistor (2),
le circuit de détection comprend une résistance de pull-up (6), une résistance de décharge (14) et un troisième transistor (3),
le circuit de retard d'Ascension de Tension comprend une première résistance (4) et un condensateur (8),
la grille du premier transistor (1) est électriquement connectée à travers la première résistance de limitation de courant (5) à la source du second transistor (2), la source du premier transistor (1) est électriquement connectée à travers la seconde résistance de limitation de courant (7) à la grille du second transistor (2), la source du premier transistor (1) est électriquement connectée à travers la première résistance (4) à la borne d'alimentation, la source du second transistor (2) est mise à la terre, le premier bout de la résistance de pull-up (6) est électriquement connecté à travers la première résistance de limitation de courant (5) à la grille du premier transistor (1), le deuxième bout de la résistance de pull-up (6) est utilisé pour être électriquement connecté à la borne d'alimentation, la grille du troisième transistor (3) est électriquement connectée à la source du second transistor (2), la source du troisième transistor (3) est électriquement connectée à travers la résistance de décharge (14) à la terre, le premier bout de la résistance de pull-up (6) est équipé d'un premier borne (10) pour la sortie du signal, la source du troisième transistor (3) est équipée d'un deuxième borne (11) pour la sortie du signal, la première entrée (12) est située entre la grille du troisième transistor (3) et le premier borne (10), la première entrée (12) est électriquement connectée à la cathode de la diode anti-diffusion (9), la première entrée (12) est utilisée pour recevoir le signal de niveau de sortie du contrôleur (15), la seconde entrée (13) est électriquement connectée à la source du premier transistor (1), la seconde entrée (13) est électriquement connectée à la grille du second transistor (2) à travers la seconde résistance de limitation de courant (7), l'anode de la diode anti-diffusion (9) est électriquement connectée à la grille du troisième transistor (3), l'anode de la diode anti-diffusion (9) est électriquement connectée à la grille du premier transistor (1) à travers la première résistance de limitation de courant (5), une extrémité du condensateur (8) est électriquement connectée à la source du premier transistor (1), l'autre extrémité du condensateur (8) est mise à la terre.

2. Selon la revendication 1, un circuit de détection d'auto-blocage, **caractérisé en ce que** le premier transistor (1), le second transistor (2) et le troisième transistor (3) sont des transistors à effet de champ.

3. Selon la revendication 2, un circuit de détection d'auto-blocage, **caractérisé en ce que** le premier transistor (1) est un transistor MOS à canal P, le second transistor (2) est un transistor MOS à canal N, le troisième transistor (3) est un transistor MOS à canal P.

4. Un appareil de détection d'auto-blocage, **caractérisé en ce qu'**il comprend un contrôleur (15) et un circuit de détection d'auto-blocage selon l'une quelconque des revendications 1 à 3, le contrôleur (15) comprenant au moins une première sortie et une seconde sortie, la première sortie étant électriquement connectée à la première entrée (12), la seconde sortie étant électriquement connectée à la seconde entrée (13).

5. Selon la revendication 4, un appareil de détection d'auto-blocage, **caractérisé en ce que** le contrôleur (15) comprend également une troisième entrée et une quatrième entrée, le premier borne (10) est électriquement connecté à la troisième entrée, le deuxième borne (11) est électriquement connecté à la quatrième entrée.

6. Selon la revendication 4, un appareil de détection d'auto-blocage, **caractérisé en ce qu'**il comprend également un dispositif d'alarme de défaut (16), le dispositif d'alarme de défaut (16) étant électriquement connecté au contrôleur (15).

7. Une méthode de contrôle d'un appareil de détection d'auto-blocage, ladite méthode étant utilisée pour contrôler un appareil de détection d'auto-blocage selon l'une quelconque des revendications 4 à 6, **caractérisée en ce que** la méthode comprend :
Lorsque le contrôleur reçoit un signal d'auto-blocage, le contrôleur envoie un signal de bas niveau à la première entrée ;
Déterminer si les signaux sortis du premier borne et du deuxième borne satisfont aux conditions prédéfinies ;
Si les conditions prédéfinies sont satisfaites, déterminer que le circuit d'auto-blocage n'a pas de défaut et que le circuit d'auto-blocage est en état d'auto-blocage.

8. Selon la revendication 7, une méthode de contrôle d'un appareil de détection d'auto-blocage, **caractérisée en ce que** la condition prédéfinie est que le signal sorti du premier borne est un signal de bas niveau et le signal sorti du deuxième borne est un signal de haut niveau.

9. Selon la revendication 7, une méthode de contrôle d'un appareil de détection d'auto-blocage, **caractérisée en outre par** :
Si les conditions prédéfinies ne sont pas remplies, alors déterminer si le nombre de fois que le circuit d'auto-blocage a échoué a atteint le nombre prédéfini de fois ;
Si le nombre de fois que le circuit d'auto-blocage a échoué a atteint le nombre prédéfini de fois, alors le contrôleur envoie un signal d'alarme ;
Si le nombre de fois que le circuit d'auto-blocage a échoué n'a pas atteint le nombre prédéfini de fois, alors augmenter le nombre de fois que le circuit d'auto-blocage a échoué d'un et débloquer le circuit d'auto-blocage, envoyer un signal de bas niveau à la première entrée et revenir à l'étape de détermination si les signaux sortis du premier borne et du deuxième borne satisfont aux conditions prédéfinies.

10. Selon la revendication 9, une méthode de contrôle d'un appareil de détection d'auto-blocage, **caractérisée en ce que** le déblocage du circuit d'auto-blocage comprend : Le contrôleur envoie un signal de bas niveau à la deuxième entrée.
